# EUROPEAN PATENT APPLICATION

(11) **EP 0 662 710 A1**
(43) Date of publication of application: **12.07.1995**
(21) Application number: 95300092.4
(22) Date of filing: 09.01.1995
(51) Int. Cl.: H01L 21/768, H01L 21/288

(54) **Method of fabricating a conducting connection between at least two metallisations of an integrated circuit**

(30) Priority: 11.01.1994 DE 4400567
(71) Applicant: TEXAS INSTRUMENTS INCORPORATED, Dallas, Texas 75243 (US); TEXAS INSTRUMENTS DEUTSCHLAND GMBH, D-85350 Freising (DE)
(72) Inventor: Rinck, Helmut, D-85350 Freising (DE); Endl, Helmut, D-85350 Freising (DE)
(74) Representative: Brown, Angela Mary

(57) **Abstract**

In a method of fabricating a conducting connection between at least two metallizations located in different conductor layers of an integrated circuit this is achieved at low cost such that it exhibits in addition to high reliability also a good electrical quality. This is achieved with the aid of an electroless deposition procedure (3) by means of which a contact via (4) formed in an insulator layer between the two metallizations to be connected is filled with a conducting material. The electroless deposition procedure (3) is promoted by cleaning and improving the wetability (1) of the contact via (4) and by activating the surface - exposed in the contact via - of the lower metallization to be connected followed by subsequent palladium seeding (2,6).

## Description

The invention relates to a method of fabricating a conducting connection between at least two metallizations in different conductor layers of an integrated circuit via at least one contact via formed in an insulator layer extending over the metallization of a lower circuit level.

In achieving integrated circuits wiring the components is one of the main tasks involved. Due to the ever-increasing number of components the number of connections between the individual components is increasing all the time. Wiring these connections is based on metallizations located in several different conductor layers. To connect metallizations located in different conductor layers conducting connections via contact vias serve, which are formed in the insulator layers between the conductor layers. The reliability and electrical quality of conducting connections of metallizations in different conductor layers thereby are of exceptional importance.

A first method of fabricating a conducting connection between the metallizations of different conductor layers is based on the cathode sputter principle. The substrate is first coated all over with TiW as the diffusion barrier and subsequently coated with aluminum in a first conductor layer. Following application of an insulator layer and producing a contact via, the latter is filled with a metal by cathode sputtering. On the surface of the metallization originally exposed in the contact via in the lower conductor layer a reduced step coverage materializes so that for e.g. a contact via of one micrometer depth and diameter the conducting cross-section is reduced to less than 20%. A second method makes use of the principle of deposition of the gaseous phase to produce the connection between the metallizations of differing circuits. Up to the cathode sputtering step this method is analogous to the first. Here, however, tungsten or copper is transferred from the gaseous phase to the substrate surface, the surface being coated all over with the metal, irrespective of the substrate. Following back etching and polishing of the deposited metal coating merely the filling of the contact via remains. In a third method which is also based on the principle of cathode sputtering, the substrate heats up to the melting point of aluminum, achieving a flow of aluminum on the substrate during cathode sputtering, this being the reason why this method is also termed aluminum reflow.

One substantial drawback of the above methods on the basis of cathode sputtering is the aforementioned deficient step coverage in the contact via, resulting in the metallization in contact with the contact via being unable to extend on a planar surface. In addition, an increased resistance value materializes for the conducting connection which results in a higher thermal stress and thus in a reduction of the reliability and life of the conducting connection. Although the methods on the basis of gas deposition or aluminium reflow techniques permit achieving a better electrical quality of the conducting connection, this is only possible with the aid of additional and exceptionally high-cost working steps.

The present invention is based on the object of achieving a conducting connection between at least two metallizations located in different conductor layers of an integrated circuit at low cost so that the latter exhibits good electrical properties in addition to high reliability.

In accordance with the present invention this object is achieved by the method as stated at the outset, in that the contact via is filled with a conducting material by an electroless deposition procedure before the metal of the second metallization is applied.

A first advantage of the method according to the invention is to be seen in that the electroless deposition procedure permits complete filling of the contact via, producing a cross-section of higher conductance in the contact via and thus also higher electrical quality and reliability of the conducting connection. A second practical advantage results from the planar termination of the filled contact via, permitting the use of a stacked arrangement of the contact vias which, in turn, permits - all-in-all - a higher wiring density for integrated circuits. Since electroless deposition is carried out in baths, the method according to the invention exhibts - as yet a further substantial advantage - an all-in-all reduced hardware requirement for a high thruput so that the conducting connections of the metallizations of different conductor layers can be achieved at extremely low cost. All of the advantages stated will gain in significance with increasing miniaturization of integrated circuits.

For a more detailled explanation of the method according to the invention, reference will now be made to the drawing, in which:
- Fig. 1: is a schematicized representation of the sequence in the steps of the method;
- Figs. 2 thru 4: illustrate the steps in the method involved on the basis of discrete intermediate results; and
- Fig. 5: shows achievement of a stacked arrangement of contact vias

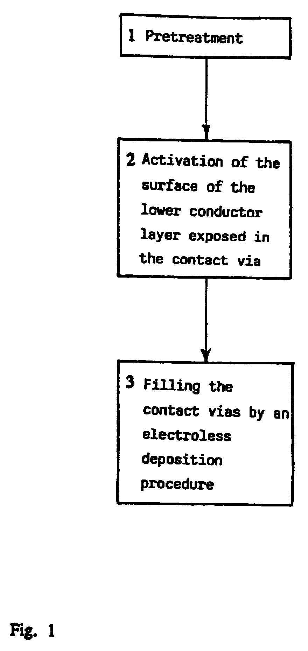

Further explanation of the preferred sequence of the method according to the invention is made on the basis of Fig. 1, in which nickel is employed for electroless deposition and metallization of the conductor layers is done with aluminium. An analogous sequence is involved should copper be electroless deposited instead of nickel.

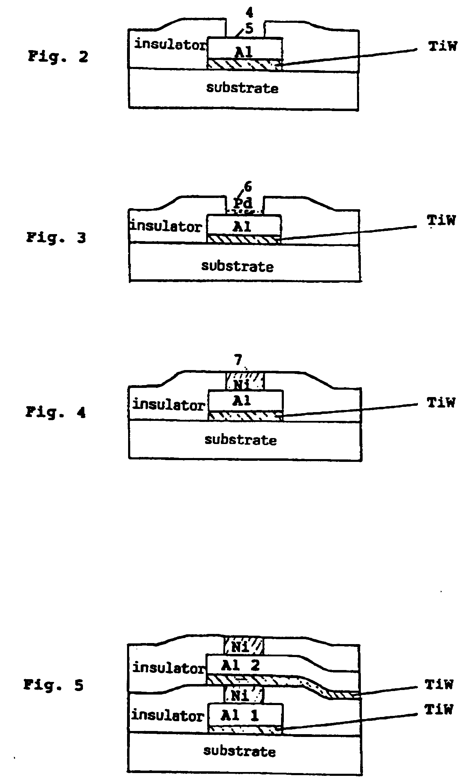

The starting point of the method according to the invention is a structure as shown in Fig. 2 with metallization of the lower conductor layer and of the insulating layer above this metallization, said isolating layer having a contact via 4 extending through down to the lower metallization.

If necessary, any oxidation and contamination is eliminated from contact via 4 in a pretreatment step 1, prior to electroless deposition, to enhance wettability of the surface to be processed. For this purpose wet chemical etching and cleaning steps serve substantially. In a further advance step 2 of the method it is possible to activate the metallization surface 5 of the lower conductor layer exposed in the contact via, to promote subsequent electroless deposition of the nickel. Activating is done by briefly dipping the structure shown in Fig. 2 into a activator solution with resulting seeding of the exposed surface 5 with palladium 6.

The contact via is then filled by an electroless deposition procedure 3 prior to metallization of the upper conductor layer. Since the contact via is filled, the nickel filling closes off level with the top edge of the contact via as shown in 7 of Fig. 4 after the previous step in the method. Since, as a result of this, the metallization connecting the contact via is able to run on a planar surface, this item is of especial significance. Also important is that this property of the method described does not depend on the metal employed for deposition, i.e. it is just as effective when the filling is made of copper. Electroless deposition is done at low cost in a nickel bath which permits a high thruput in the fabrication of integrated circuits.

Yet a further preferred sequence of the method according to the invention serves to achieve coated contacts vias as shown in Fig. 5 and and corresponds substantially to twice the sequence of steps in the method shown in Fig. 1, whereby between the first and second sequence an aluminium metallization is applied to the planar covering surface of the contact via filled in the first sequence, together with an intermediate TiW diffusion barrier, if required. Accordingly a structure results in which it is possible to produce one contact via directly above the other. This embodiment of the method described is then particularly of advantage when integrated circuits need to be fabricated with exceptionally high package densities.

## Claims

1. A method of fabricating a conducting connection between at least two metallizations in different conductor layers of an integrated circuit via at least one contact via formed in an insulator layer extending over the metallization of a lower circuit level, characterized in that the contact via is filled with a conducting material by an electroless deposition procedure before the metal of the second metallization is applied.

2. The method as set forth in claim 1, characterized in that the conducting material is nickel.

3. The method as set forth in claim 1, characterized in that the conducting material is copper.

4. The method as set forth in any of the claims 1 thru 3, characterized in that prior to filling the contact via a pretreatment step for cleaning and improving the wetability of the contact via is executed.

5. The method as set forth in any of the preceding claims, characterized in that prior to filling the contact via the surface of the lower conductor layer exposed by the contact via is activated by the effect of an activator solution with subsequent palladium seeding.
